(19) Europäisches Patentamt
European Patent Office
Office européen des brevets

(11) **EP 4 768 934 A1**

(12) **EUROPEAN PATENT APPLICATION**

(43) Date of publication:
**01.07.2026 Bulletin 2026/27**

(21) Application number: **25213856.5**

(22) Date of filing: **06.11.2025**

(51) International Patent Classification (IPC):
**G01R 31/367** (2019.01)   **G01R 31/382** (2019.01)
**G01R 31/389** (2019.01)   **G01R 31/392** (2019.01)

(52) Cooperative Patent Classification (CPC):
**G01R 31/392; G01R 31/367; G01R 31/382; G01R 31/389**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH LA MA MD TN**

(30) Priority: **27.12.2024 US 202419003541**

(71) Applicant: **TOYOTA MOTOR ENGINEERING & MANUFACTURING NORTH AMERICA, INC.**
**Plano, TX 75024 (US)**

(72) Inventor: **ISHIGAKI, Masanori**
**Plano, Texas 75024 (US)**

(74) Representative: **Winter, Brandl - Partnerschaft mbB**
**Alois-Steinecker-Straße 22**
**85354 Freising (DE)**

(54) **SYSTEMS AND METHODS FOR ESTIMATING A RESIDUAL VALUE FOR A USED BATTERY WITH A SAFETY STATE AND A HEALTH STATE**

(57)    Systems and methods herein relate to estimating a residual value of a used battery from deriving a safety state using derivative computations of measured impedance and a health state for reuse applications. In one embodiment, a method includes measuring impedance for a used battery by testing equipment with a target temperature and a target state of charge (SOC), and the target temperature and the target SOC associated with chemical activity of the used battery. The method also includes removing interference sources by computing first derivatives of realparts from the impedance. The method also includes estimating a residual value from a safety state and a health state derived with changes of the first derivatives within a frequency band. The method also includes transmitting the residual value to a device and drawing power from the used battery by the device during a reuse operation upon the residual value satisfying a parameter.

**FIG. 3A**

EP 4 768 934 A1

**Description**

TECHNICAL FIELD

The subject matter described herein relates, in general, to estimating a residual value of a used battery, and, more particularly, to estimating the residual value using derivative computations of a safety state and a health state for reuse applications.

BACKGROUND

A system running a vehicle with a traction battery is a clean and sustainable alternative to using fossil fuels. Besides reducing greenhouse emissions, electric vehicles (EVs) powered by batteries can lower fuel and maintenance costs that improve the economics for consumers. However, disposing the traction battery can be harmful to the environment due to metallic materials. For instance, lithium-ion batteries in a landfill leak toxic chemicals like cobalt, nickel, and manganese into the soil and water. Many traction batteries use liquid electrolytes that are a fire hazard in landfills and recycling facilities. Thus, environmental benefits of traction batteries in an EV exhibit counteracting harm to the environment at an end-of-life (EoL).

In various implementations, systems can reuse a traction battery at the EoL for socalled second-life applications. For instance, a traction battery produces sufficient power as a backup source for residential applications. However, regular wear and internal degradation to the traction battery during initial deployment can impact health and limit reuse applications. Internal degradation includes metallic plating occurring during battery charging where lithium ions deposit as metallic lithium on an anode. Plating can significantly degrade battery performance by reducing the available lithium for energy storage, increase internal resistance, and increase safety hazards from short circuits. Furthermore, systems detecting plating encounter difficulties since the phenomenon occurs microscopically within cells that demands specialized and expensive equipment. Therefore, reusing a traction battery has challenges associated with physical and chemical breakdown that are costly and difficult to detect, thereby reducing applications and increasing hazards for reuse opportunities.

SUMMARY

In one embodiment, example systems and methods relate to estimating a residual value of a used battery from deriving a safety state using derivative computations of measured impedance and a health state for reuse applications. In various implementations, systems reuse a battery pack originally powering an electric vehicle (EV), a house, etc., at an end-of-life (EoL). Used batteries can have limited applications for second-life implementations from degradation caused by recharging and physical damage during travel (e.g., collisions, road debris, etc.) that creates safety hazards during reuse. Systems recycle a battery pack having reuse applications from unknown defects internally that are difficult to diagnose. For example, metallic plating occurs in a battery pack from the EV having increased charging rates and exposure to low temperatures. Systems may dissemble the used battery using complex machinery to detect plating on contacts associated with battery cells. Disassembly can damage sensitive components and controllers near the battery cells. In one example, disassembling the battery pack for diagnosing plating by scanning electron microscopy (SEM) and nuclear magnetic resonance (NMR) damages internal sensors, controllers, and cell packaging. Thus, physical and chemical degradation create unsafe conditions for reusing a battery and detecting the conditions can involve disassembly that increases complexity.

Therefore, in one embodiment, an estimation system predicts a residual value of a used battery by deriving a health state and a safety state using first derivative computations of impedance for reuse and second-life applications. In one approach, the estimation system identifies features for diagnosing the safety state and metal plating at a module level instead of a cell level using the first derivative computations, thereby reducing testing costs and complexity. Here, a state of functionality representing the residual value can also be directly derived from the health state and the safety state, where the health state indicates remaining capacity of the used battery. Furthermore, the estimation system reduces complexity by removing interference sources within the module that are linear and constant using non-invasive equipment and external measurements. This avoids damage to internal cells and sensitive equipment of the used battery.

Moreover, the interference sources can exhibit first derivative values from the impedance measurements that are unchanged and negligible (e.g., zero). The estimation system measuring the impedance at a frequency band according to the internal architecture of the used battery where the interference sources are dominant and pronounced further improves detection accuracy and sensitivity. Accordingly, the estimation system reliably detects a residual value of a used battery through non-invasive techniques using derivative computations at a module level and identifies reuse applications for the used battery that mitigates environmental waste.

In one embodiment, an estimation system that predicts and estimates a residual value of a used battery from deriving a safety state using derivative computations of measured impedance and a health state for reuse applications is disclosed. The estimation system includes a memory including instructions that, when executed by a processor, cause the processor to measure impedance for a used battery by testing equipment with a target temperature and a target SOC, and the target temperature and the target SOC associated with chemical activity of the used battery. The instructions also include instructions to remove interference sources by computing first derivatives of real-parts from the impedance. The instructions also include instructions to estimate a residual value from a safety state and a health state derived with changes of the first derivatives within a frequency band. The instructions also include instructions to transmit the residual value to a device and the device draws power from the used battery during a reuse operation.

In one embodiment, a non-transitory computer-readable medium for estimating a residual value of a used battery from deriving a safety state using derivative computations of measured impedance and a health state for reuse applications and including instructions that when executed by a processor cause the processor to perform one or more functions is disclosed. The instructions include instructions to measure impedance for a used battery by testing equipment with a target temperature and a target SOC, and the target temperature and the target SOC associated with chemical activity of the used battery. The instructions also include instructions to remove interference sources by computing first derivatives of real-parts from the impedance. The instructions also include instructions to estimate a residual value from a safety state and a health state derived with changes of the first derivatives within a frequency band. The instructions also include instructions to transmit the residual value to a device and the device draws power from the used battery during a reuse operation. The instructions to transmit the residual value to a device and the device draws power from the used battery during a reuse operation may be performed upon the residual value satisfying a parameter.

In one embodiment, a method for estimating a residual value of a used battery from deriving a safety state using derivative computations of measured impedance and a health state for reuse applications is disclosed. In one embodiment, the method includes measuring impedance for a used battery by testing equipment with a target temperature and a target SOC, and the target temperature and the target SOC associated with chemical activity of the used battery. The method also includes removing interference sources by computing first derivatives of real-parts from the impedance. The method also includes estimating a residual value from a safety state and a health state derived with changes of the first derivatives within a frequency band. The method also includes transmitting the residual value to a device and drawing power from the used battery by the device during a reuse operation upon the residual value satisfying a parameter.

## BRIEF DESCRIPTION OF THE DRAWINGS

The accompanying drawings, which are incorporated in and constitute a part of the specification, illustrate various systems, methods, and other embodiments of the disclosure. It will be appreciated that the illustrated element boundaries (e.g., boxes, groups of boxes, or other shapes) in the figures represent one embodiment of the boundaries. In some embodiments, one element may be designed as multiple elements or multiple elements may be designed as one element. In some embodiments, an element shown as an internal component of another element may be implemented as an external component and vice versa. Furthermore, elements may not be drawn to scale.

FIG. 1 illustrates one embodiment of an estimation system that is associated with estimating a residual value of a used battery from deriving a safety state using derivative computations of measured impedance and a health state for reuse applications.
FIGS. 2A-2C illustrate examples of detecting plating, measuring a health state, and predicting a residual value for the used battery.
FIG. 3A and 3B illustrate examples of interference sources the estimation system can mitigate and remove using first derivative computations.
FIG. 4 illustrates one embodiment of a method that is associated with estimating a residual value from a safety state derived with changes of first derivatives and a health state.

## DETAILED DESCRIPTION

Systems, methods, and other embodiments associated with estimating a residual value of a used battery from deriving a safety state using derivative computations of measured impedance and a health state for reuse applications are disclosed herein. In various implementations, systems testing health and safety conditions (e.g., metallic plating) for reusing batteries involves measurements acquired from complex equipment. Metallic plating is an internal condition where a superficial layer forms on an anode from improper intercalation of ions into anode material that compromises safety. For a lithium battery powering an electric vehicle (EV), the superficial layer is lithium ions accumulating on the anode surface that interferes with current output and diminishes overall power generation. High frequency-electrochemical impedance spectroscopy (HF-EIS) equipment measures cell-level plating for systems estimating battery interference (e.g., contact interference, metal plating, etc.) from metallic materials (e.g., lithium-ion). This equipment is costly and measurements encounter difficulties for detecting plating since a battery has tightly integrated hardware and battery cells with limited direct access unlike a short within internal circuitry. Directly accessing cells through disassembly can involve tasks that damage the used battery, thereby precluding reuse applications.

In another approach, systems using non-destructive techniques such as ultrasonic inspection for testing health and safety conditions involve sophisticated equipment that hinders testing adaptation. Furthermore, alternate systems measuring at a module level encounter difficulties associated with interference from structural changes in the battery pack (e.g., case deformations, accidental damage, physical holes, etc.). Accordingly, systems testing a used battery for health and safety conditions and estimating a residual value have challenges with detection technologies involving sophisticated equipment and invasive disassembly, thereby hindering reuse applications.

Therefore, in one embodiment, an estimate system estimates a residual value of a used battery by deriving a safety state using first derivative computations of real-parts from impedance and a health state. The residual value can indicate second life and reuse opportunities for the used battery (e.g., an electric vehicle (EV) battery). For instance, the residual value is a functionality state directly related to the safety state and the health state. Furthermore, the estimation system can measure the health state (e.g., charging capacity) and identify features for diagnosing the safety state and metal plating at a module level instead of a cell level using the first derivative computations. A module can be located within a battery pack of an EV and include multiple cells, a cell array, etc., exhibiting potentially degraded states from powering a device (e.g., an EV). This way, the estimation system can accurately derive the residual value of cells within the used battery from the first derivative of real values while avoiding invasive and complex testing.

In various implementations, the estimation system selects a frequency band for testing such that the frequency band factors a cell layout and chemical properties of the used battery. For example, the frequency band is above a frequency having increased chemical breakdown and an elevated ion (e.g., lithium-ion) response that improves testing robustness for the used battery. Furthermore, the estimation system identifies and factors temperature and state of charge (SOC) to measure impedance such that first derivative computations of the impedance emphasize and elevate plating activities. In another approach, the estimation system computes the safety state using first derivative computations to also remove certain interference sources (e.g., contact interference, inductive interference, etc.) that are unchanged and negligible (e.g., zero) for a cell, a cell array, etc., from a module level. This allows non-invasively and accurately identifying plating, degradation, etc., of a terminal within the used battery externally and avoids disassembly using changes of first derivative values for impedance, thereby improving testing.

Moreover, estimating the residual value from the safety state can involve extracting operating qualities over certain safety-related features of the used battery. The safety-related features can include SOC, temperature, induction, etc. Accordingly, the estimation system can reliably and accurately estimate the residual value and safety of the used battery for reuse applications from first derivative computations while using non-invasive measures that reduce testing complexity and component damage.

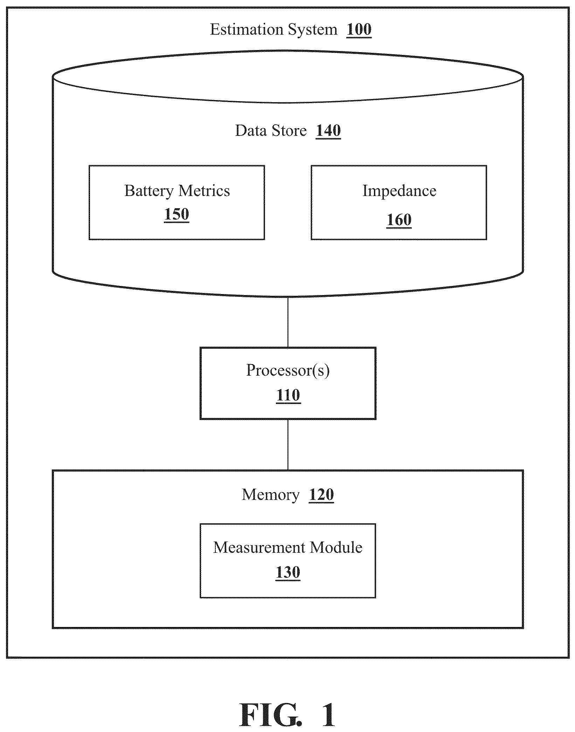

In certain implementations, the systems illustrated in FIGS. 1-4 also include various elements. It will be understood that in various embodiments, the systems may have less than the elements shown in FIGS. 1-4. The systems can have any combination of the various elements shown in FIGS. 1-4. Furthermore, the systems can have additional elements to those shown in FIGS. 1-4. In some arrangements, the systems may be implemented without one or more of the elements shown in FIGS. 1-4. While the various elements are shown as being located within the systems in FIGS. 1-4, it will be understood that one or more of these elements can be located external to the systems. Furthermore, the elements shown may be physically separated by large distances. Additionally, it will be appreciated that for simplicity and clarity of illustration, where appropriate, reference numerals have been repeated among the different figures to indicate corresponding or analogous elements. In addition, the discussion outlines numerous specific details to provide a thorough understanding of the embodiments described herein. Those of skill in the art, however, will understand that the embodiments described herein may be practiced using various combinations of these elements.

With reference to FIG. 1, one embodiment of the estimation system 100 that is associated with estimating a residual value of a used battery from deriving a safety state using derivative computations of measured impedance and a health state for reuse applications is illustrated. In one approach, systems monitoring, identifying, etc., internal growth of Li-metal deposition is vital for deriving and identifying a state of safety (SOS) of the lithium-ion batteries. The internal growth is a factor associated with reducing thermal runaway temperature of lithium-ion batteries, thereby increasing reuse applications that are safe. Along these lines, the estimation system 100 and the measurement module 130 can measure the impedance for the used battery by testing equipment with a target temperature and a target SOC. For example, the target temperature and the target SOC are associated with levels exhibiting robust chemical activity of the used battery. Furthermore, the estimation system 100 removes interference sources by computing first derivatives of real-parts from the impedance. This allows the estimation system to output a safety state indicating metallic plating and a residual value (e.g., remaining functionality, power reliability, etc.) about the used battery at the module level while avoiding impedance tracking. In this example, impedance tracking can demand a system measuring impedance to acquire internal sensor data that is unavailable from third-party manufacturers. Impedance tracking can also involve accessing manufacturing details and schematics that are proprietary, thereby having limited access.

Moreover, the estimation system 100 estimates the residual value from the safety state and a health state derived with changes of the first derivatives within a frequency band for the used battery. For example, the frequency band is above a frequency having increased chemical breakdown and an ion (e.g., lithium-ion) response that is elevated and robust for testing the used battery. Upon the residual value satisfying a parameter, other systems can reuse the used battery to power a device. For instance, the estimation system 100 transmits the residual value to a device and the device draws power from the used battery during a reuse operation upon the residual value satisfying a parameter.

In FIG. 1, the estimation system 100 is shown as including a processor(s) 110 and a memory 120. In one embodiment, the memory 120 stores a measurement module 130 that acquires data from testing equipment, testing sensors, etc., about a used battery. For example, the measurement module 130 generally includes instructions that function to control the processor(s) 110 to receive data inputs from one or more sensors of the testing equipment. For instance, the testing equipment measures impedance using hardware that apply a minimal alternating current (AC) signal into a module, cell, etc., and measures the response. Such testing equipment can precisely output detailed information about the internal resistance and reactance of a battery, such as a high-voltage battery used by an EV.

In one implementation, the memory 120 is a random-access memory (RAM), a read-only memory (ROM), a hard-disk drive, a flash memory, or other suitable memory for storing the measurement module 130. The measurement module 130 is, for example, computer-readable instructions that when executed by the processor(s) 110 cause the processor(s) 110 to perform the various functions disclosed herein. Furthermore, in one embodiment, the estimation system 100 includes a data store 140 operating as a database. The database is, in one embodiment, an electronic data structure stored in the memory 120 or another data store and that is configured with routines that can be executed by the processor(s) 110 for analyzing stored data, providing stored data, organizing stored data, and so on. Thus, in one embodiment, the data store 140 stores data used by the measurement module 130 in executing various functions.

In another example, the data store 140 includes battery characteristics 150 and impedance 160. The battery characteristics 150 can include data about one of a SOC, a temperature, a health state, a state of health (SOH), a remaining capacity, a charging capacity, and a safety state associated with a used battery. Testing equipment can measure the health state using acquired sensor data about the used battery that is stored as the battery characteristics 150. For instance, the sensor data includes an output voltage, an operating temperature, and impedance at reduced temperatures.

As further explained below, the estimation system 100 includes testing equipment that measures impedance at a module level for the used battery and executes computations involving first derivatives of the impedance. This allows removing interference sources having first derivative properties for impedance that are unchanged and negligible (e.g., zero). This also allows estimating a residual value from a health state and a safety state for one or more cells within a module of the used battery without invasive disassembly and expensive diagnostic equipment, thereby reducing system complexity.

In another embodiment, the battery characteristics 150 can include the safety state that indicates plating within a cell, a cell array (e.g., twelve cells), a module, etc., internal to the used battery and a frequency band where the plating is prominent. The safety state can involve extracting operating qualities over certain safety-related features of the used battery (e.g., SOC, temperature, induction, etc.). Plating can involve forming a metallic layer on an anode surface of the cell from improper intercalation of lithium ions into anode material and the lithium ions accumulating on the anode surface. Here, the frequency band can be above a frequency having increased chemical breakdown and an ion response that is elevated associated with the used battery. The battery characteristics 150 can also include a parameter associated with the safety state indicating that one of a cell and the module internal within the used battery has undetected plating on a surface of an anode associated with a threshold (e.g., a current output, a voltage output, etc.).

The battery characteristics 150 can include a SOC that is one of a charge level and a discharge level associated with chemical degradation. Furthermore, the battery characteristics 150 can include a functionality state for the used battery using the safety state and the health state. For instance, the functionality state can be a residual value of the used battery as a power source in a reuse application. As further explained below, the residual value or functionality state can be directly correlated with the safety state and the health state for the used battery. In one approach, the estimation system 100 outputs the residual value by multiplying values of the safety state and the health state. In this way, systems can utilize the outputs to identify lithium deposition that makes the used battery unsafe for second-life applications and potential reuse opportunities from the residual value.

The impedance 160 can include a measure of the opposition to electrical flow expressed using complex-valued generalization and Ohm ($\Omega$) units. As such, impedance is similar to resistance in direct current (DC) systems. In AC systems, impedance incorporates reactance due to frequency-dependent contributions from capacitance and inductance. As such, impedance in an AC system is still measured in $\Omega$ units by the equation $Z = V/I$ having $V$ and $I$ that are frequency-dependent.

Still referring to FIG. 1, the estimation system 100 and the measurement module 130 include instructions that cause the processor 110 to detect physical and chemical changes about the internal state of a battery (e.g., a lithium-ion battery) from impedance measurements. In one approach, a frequency band for impedance measurements exceeds a frequency (e.g., 100 Hz, 1 kHz, 1 MHz, etc.) where the ion response inside the battery is dominant. This allows the estimation system 100 to accurately diagnose causes of impedance changes from impedance values and a first derivative for a frequency, such as variable frequencies $f_1$ to $f_2$. A diagnosis can include one of a safety state, the existence of lithium metal deposition, lithium plating inside at least one cell of a battery, and a residual value. For example, the residual value is one of a state of functionality and a state of function (SOF) associated with the used battery and the residual value indicates a degree of the used battery available as a power source in a reuse application. For instance, the reuse application is one of an industrial reuse, a residential reuse, and a commercial reuse for the used battery. The residual value exceeding a minimal parameter, threshold, etc., can indicate that one or more cells within the used battery exhibit sparse plating or lack metallic plating, thereby increasing opportunities for reuse rather than recycling and creating waste. Otherwise, the residual value may indicate that the used battery is unsuitable and unsafe for reuse opportunities and the used battery should be recycled.

Moreover, different degrees of the residual value can indicate available applications for reuse. For instance, an average residual value indicates that the used battery can be reliably used as a backup source for a house. This application may have reduced demands for safety and quality of service (QoS). Critical applications can demand a residual value that is elevated for the used battery. This can include the used battery being a main power source for hospitals, powering medical equipment, a power source for a chemical plant, etc. In another approach, the SOF weights a state of safety (SOS) with a SOH and forms Equation (1):

$$SOF = \alpha \; x \; SOH \; x \; SOS. \quad \text{Equation (1)}$$

Here, the variable $\alpha$ can be a weighting factor that can depend upon one of a battery chemistry, a cellular structure, casing material, application environment, usage environment (e.g., commercial backup, an electric vehicle), etc. As such, the variable $\alpha$ can incorporate and factor additional context to SOF for the used battery besides SOH, thereby improving reuse determinations. For example, the estimation system 100 computes a functionality state, SOF, etc., for the used battery using the safety state and the weighting factor, and the SOH. The functionality state can indicate a residual value of the used battery as a power source in a reuse application.

In Equation (1), the SOH can indicate one of a remaining capacity and a charging capacity of the used battery. SOH can also be reuse-dependent using classes. For instance, a class for vehicle reuse demands an elevated SOH (e.g., 90%) for charging capacity while residential reuse can tolerate a lower SOH (e.g., 80%). In one approach, the estimation system 100 derives the SOH using output voltage, average operating temperature, and impedance from the average temperatures. As such, the estimation system 100 can reliably output one of a safety state that indicates degradation such as metallic plating and a residual value for the used battery. This allows related systems to identify that the used battery is viable for reuse and target particular applications. Otherwise, the systems generate a recycling plan from the output since the used battery is defective and worn beyond repair.

There are additional approaches that include the estimation system 100 targeting optimal temperature, the SOC, and impedance for computing the residual value and detecting the safety state. For instance, the estimation system 100 measuring impedance at target temperatures and SOCs parameters improves the effectiveness of plating detection, computing a safety state, and deriving a residual value using first derivative computations. These parametric targets can depend upon the internal architecture, cell layout (e.g., stacked layers, parallel, rolled cells, etc.) and chemistry profile of a used battery. The estimation system 100 can adapt these parametric targets during impedance measurement involving the used battery that further improve computational accuracy.

Moreover, in another approach, the estimation system 100 selects a frequency band according to a cell layout and internal architecture (e.g., cylindrical cells, stacked sheets, etc.) of a used battery. As previously explained, the frequency band can be associated with the testing equipment measuring impedance from the used battery when the ion response internally at a cell is dominant. Furthermore, the estimation system 100 and the measurement module 130 can filter wear interference and measurement noise (e.g., sensor interference) to the used battery using the frequency band. In this way, the estimation system 100 can at a module level diagnose causes of impedance changes from measurements and real-parts of a first derivative for a cell accurately while reducing testing and computational complexity.

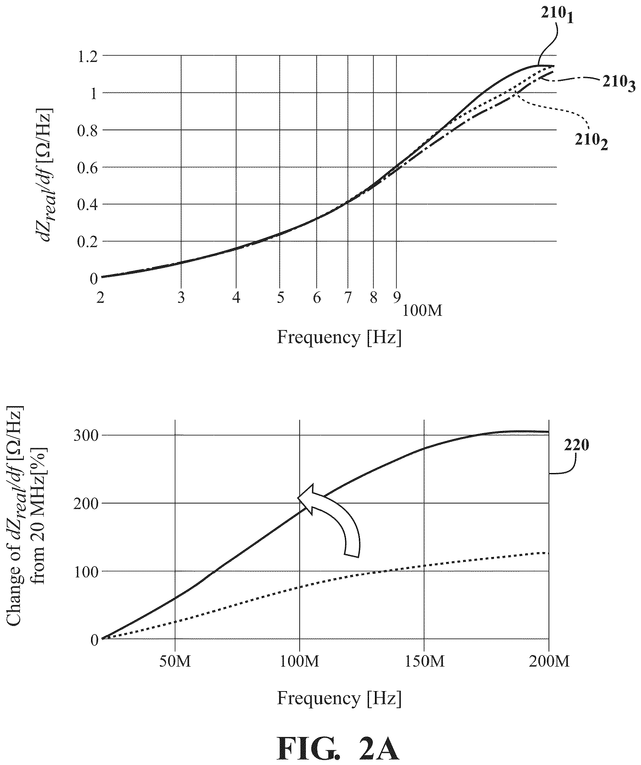

Turning to FIGS. 2A-2C, examples of detecting plating, measuring a health state, and predicting a residual value for a used battery are illustrated. The estimation system 100 may compute one or more of the following first derivatives using impedance measurements from the used battery: a first derivative of a real-part from an impedance value, a first derivative of an imaginary-part from the impedance value, a difference between real-parts from first derivatives of impedance values among two frequency points, a difference between imaginary-parts from first derivatives of impedance values among the two frequency points, the real-part of the impedance value, and the imaginary-part of the impedance value. For instance, the two frequency points are the variable frequencies $f_1$ to $f_2$ within a frequency band exhibiting increased chemical breakdown and an ion response associated with the used battery. This allows the estimation system 100 to reliably and non-invasively detect internal degradation and plating using first derivative computations at a module level. Although examples reference two, any number of frequency points may be used for impedance computations described herein. Furthermore, derivative computations can proceed upon filtering impedance measurements for noise by intelligently selecting the frequency band through accounting for battery architectures and profiles. The first derivative is also a practical and low-cost approach for filtering high-frequency interference from sources described below. Unlike the second derivative, the first derivative is noise-resistant for certain interference types.

In another approach, the estimation system 100 measures impedance at target temperatures and SOCs that improve the effectiveness of detecting degradation and computing a residual value using first derivative computations. These targets can depend upon the internal architecture and chemistry of a used battery. Furthermore, the first derivative of the real-parts from impedance exhibits properties that allow the estimation system 100 to target metal deposition and degradation (e.g., a chemical degradation, a physical degradation, etc.) through mitigating interference sources. Correspondingly, the estimation system 100 can accurately compute a SOF for the used battery during testing from the interference sources associated with one of a cell, a module, a cell array, etc., within the used battery.

Other examples include the estimation system 100 detecting internal degradation of one of a battery cell and a module and computing the residual value externally. This technique avoids invasive and complex testing that demand disassembly. Here, the first derivative nullifies, eliminates, removes, mitigates, etc., contact interference for the used battery during impedance measurements at selected frequency bands. Contact interference (e.g., iron contacts, copper contacts, etc.) may originate from internal cells within a battery module experiencing a loosening, tightening, etc., for a coupling between terminals, contact tabs, etc. In some cases, the interference from terminal contact is independent of a frequency response.

The difference between the real-parts from the first derivatives of the impedance values among the two frequency points can nullify, mitigate, eliminate, remove, etc., inductive interference (e.g., iron-based induction). Inductive interference from iron and a contact interference associated with one of a cell, a module, a cell array, etc., within the used battery can represent another interference source. The estimation system 100 converting real-parts of impedance to a percentage value can further minimize inductive interference (e.g., eddy current) when detecting degradation and computing a residual value. This can also emphasize changes caused from metallic plating through observing linear relationships and reduce computations through monotonically increasing relationships rather than higher-order tasks. Furthermore, in one embodiment, the estimation system 100 includes an analysis algorithm that retrieves context parameters about the used battery. For instance, the estimation system 100 factors the context parameters and the difference between real-parts from first derivatives of impedance values among the two frequency points when selecting a threshold for the safety state. The first derivatives can be compared against the threshold to gauge a degradation level. Here, a system analyzing the residual value can diagnose other defects besides internal degradation, plating, etc. In one approach, the threshold is associated with a plating level involving a particular battery chemistry (e.g., lithium-ion), usage profile (e.g., harsh weather, rough terrain, aggressive driving, etc.), etc. In this way, the estimation system 100 increases the reliability and accuracy of the safety state and residual value outputs through intelligently selecting the threshold.

In another approach, the estimation system 100 estimates one of a safety state, a SOF, and the physical degradation for the used battery through computing eddy interference. Here, the estimation system 100 can utilize a linear relationship derived from first derivatives of real-parts associated with impedance measurements. This allows the estimation system 100 to diagnose the physical degradation as one of material wear, solid electrolyte interphase (SEI) growth, and an eddy current from inductive interference while avoiding complex testing tasks and equipment. This can include the estimation system 100 computing eddy interference for the interference sources using a linear relationship derived from the first derivatives of real-parts associated with measured impedance. The estimation system 100 can identify plating of a terminal within the used battery by comparing a difference between multiple values (e.g., two) of a first derivative within the frequency band with a threshold, and use the testing equipment to identify the plating without dissembling cells associated with the used battery and calculate the safety state using a degree of the plating.

In certain examples given herein, the estimation system 100 identifies plating of a terminal within the used battery from a difference between two values of a first derivative within the frequency band using the testing equipment without disassembling cells associated with the used battery. Furthermore, the estimation system 100 can compute a safety state for the used battery without impedance tracking from a timepoint that the used battery is manufactured upon satisfaction of a cycling parameter. For instance, the cycling parameter represents a number of cycles and extreme operating temperatures experienced by the used battery. In this way, the estimation system 100 can output a safety state and a residual value about the used battery that indicates an available degree of the used battery being a power source in a reuse application.

Concerning FIG. 2A, the estimation system 100 computes changes of first derivatives for real-parts between various interference sources $210_1$ to $210_3$ across

different frequencies associated with impedance measurements. Here, testing equipment can non-invasively acquire impedance measurements externally at a module level from a used battery pack for computations by the estimation system 100. This technique avoids disassembly-related damage when accessing battery cells for measuring the interference sources $210_1$ to $210_3$.

The interference source $210_1$ may represent plating associated with one of a cell, a module, etc., within a used battery. The interference source $210_2$ can represent contact interference, contact interference plating, etc., associated with one of a battery module, a cell, etc. For instance, contact interference originates from internal cells within a battery module experiencing a loosening, tightening, etc., for a coupling between terminals. The interference source $210_3$ can represent a metal material external to the used battery effecting one of a battery module, a cell, etc., within the used battery. In these examples, the impedance changes of the first derivatives for the real-parts between two or more frequency points can indicate an interference source and related degrees. Furthermore, the estimation system 100 for the Y-axis in 220 can convert to a percentage value. This conversion further minimizes contact interference and emphasizes impedance changes from metallic plating (e.g., Li-plating) for improved plating detection by the estimation system 100.

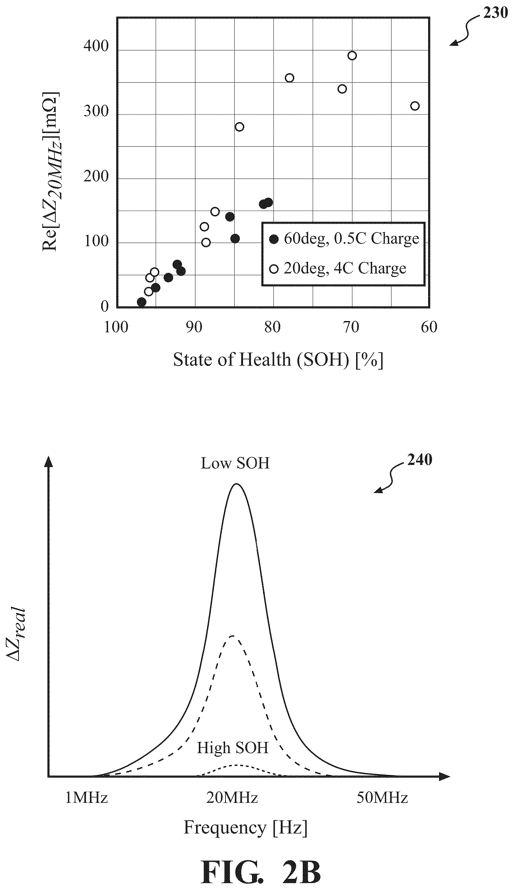

FIG. 2B illustrates chart 230 comparing the relationship between SOH (e.g., remaining charge) and changes of real-parts from impedance measurements associated with a used battery. Here, the changes can be among impedance between frequency points of 20 MHz represented as milliOhms (mΩ). The measurement module 130 measures SOH in this example at 60 degrees Celsius and a 0.5C C-rate. A C-rate represents that a fully charged battery with a capacity of 1 amperes hours (Ah) and temperature x should output 1A for one hour. Decreasing chemical reactions limit output current and lowers an effective C-rate when a used battery is operating at a low temperature. However, both very high and very low temperatures can damage a used battery and accelerate internal degradation, thereby causing safety concerns.

In chart 230, the estimation system 100 identifies limited plating and degradation at 60 degrees Celsius with a 0.5C C-rate and elevated SOH using first derivative computations for impedance. In another example, estimation system 100 detects internal degradation and plating within a module using first derivative computations of real-parts from impedance measurements with 4C C-rate at 20 degrees Celsius for a limited SOH. As such, the chart 230 illustrates that real-parts of impedance can be elevated at lower temperatures than higher temperatures among different C-rates indicating potential degradation, plating, etc.

Moreover, chart 240 exhibits the measurement module 130 finding decreased SOH when differences between real-parts of impedance are elevated at 20 MHz frequency bands, increments, etc. This frequency analysis differs from a frequency range utilized by the estimation system 100 for internal degradation (e.g., plating). Meanwhile, the measurement module 130 detects increased SOH when real-parts of impedance are increased at certain values of 20 MHz. In one approach, SOH estimation by 20 MHz impedance is unrelated to SOS and plating detection. However, SOH estimation can improve SOF derivations by utilizing the same impedance analyzer to estimate SOS using derivative computations and SOH by 20MHz changes. Thus, the estimation system 100 can factor these effects when detecting degradation and computing a residual value for a used battery.

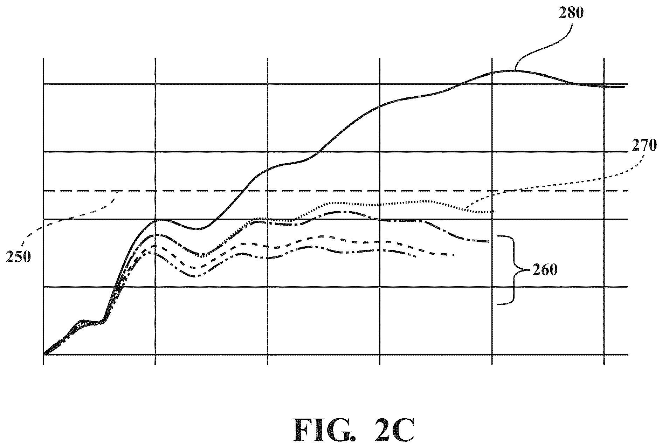

In various implementations, FIG. 2C illustrates raw values of first derivatives for real-parts from impedance measurements using testing equipment. Here, the estimation system 100 and the measurement module 130 derive the raw values from various batteries and compare the first derivative values for the real-parts against a threshold 250. As previously explained, the estimation system 100 can retrieve context parameters about a used battery and factor the context parameters and the difference between real-parts from first derivatives of impedance values when selecting a threshold. Here, the threshold 250 can indicate degrees when the safety state and the residual value allow a reuse application for the used battery. As such, the threshold 250 can be a plating level associated with one of a battery chemistry (e.g., lithium-ion), a usage profile (e.g., harsh weather, aggressive driving, etc.), etc.

As an example, the raw values over time for batteries 260 remain below the threshold 250 indicating that the batteries 260 have elevated residual values and the batteries 260 are free from plating. As such, systems have opportunities for reusing used batteries in diverse applications. Battery 270 can be available for reuse outside of mission-critical applications (e.g., residential) since the first derivative values for real-parts from impedance are near the threshold 250. This can also indicate a residual value that is limited and potential plating internally that goes undetected. Furthermore, the output of the estimation system 100 can indicate recycling battery 280 since the raw values of first derivative values are above the threshold 250. Here, the battery 280 may have one or more cells with metallic plating and other degradation (e.g., a chemical degradation, a physical degradation, etc.) to a degree that makes reuse impractical and unsafe. The estimation system 100 can also predict that the battery 280 has a minimal residual value for reuse applications.

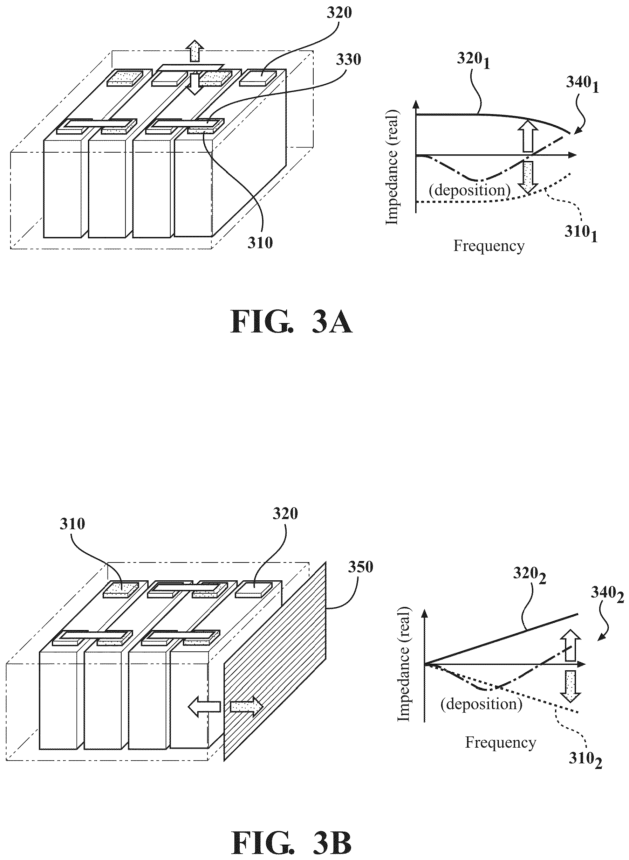

Regarding FIG. 3A and 3B, examples of the estimation system 100 mitigating and removing interference sources from measured impedance using first derivative computations are illustrated. As previously explained, the estimation system 100 can target predicting one of metal deposition and a safety state through mitigating interference sources for a used battery during testing with the first derivative of the real-parts from the measured impedance. The safety state can involve extracting operating qualities over certain safety-related features associated with the used battery (e.g., SOC, temperature, induction, etc.). The interference sources can be associated with one of a cell, a module, a cell array, etc., within the used battery. Here, the estimation system 100 can avoid invasive and complex testing through the first derivative computations detecting the interference sources for internal cells externally at a module level. Furthermore, the estimation system 100 measuring impedance at target temperatures and SOCs exhibiting increased chemical reactivity can improve the effectiveness of detecting degradation (e.g., a chemical degradation, a physical degradation, etc.) and a residual value using first derivative computations. For instance, a target SOC is 20% for residential reuse applications that are non-critical while 85% for critical applications. The SOC target can depend upon an internal architecture and chemistry of the used battery. As previously described, the estimation system 100 can factor SOC and adapt a target for reuse applications when testing the used battery, thereby further improving computational accuracy.

Computing the first derivative also nullifies, mitigates, eliminates, removes, etc., contact interference for a used battery during impedance measurements involving selected frequency bands. Contact interference may be from internal cells within a battery module experiencing a loosening, tightening, etc., for a coupling between terminals that is readily measurable within a frequency band. In FIG. 3A, for example, the estimation system 100 mitigates contact interference when measuring impedance from the used battery. Here, the battery has a negative terminal 310 and a positive terminal 320 between internal cells, modules, etc., as contact tabs. As previously explained, contact interference may be from the internal cells within a battery module experiencing a loosening, tightening, etc., for a coupling 330 between terminals, contact tabs, etc. The estimation system 100 can encounter reduced accuracy to impedance measurements from contact interference. As such, the first derivative removing contact interference for the used battery during impedance measurements improves accuracy and reliability for detecting battery degradation and estimating a residual value and a safety state.

In FIG. 3A, the estimation system 100 may convert real-parts of impedance to a percentage value for minimizing inductive interference from eddy currents. This conversion can also magnify changes caused from metallic plating through observing linear relationships. Another benefit from the technique is reducing computational complexity with monotonically increasing relationships and avoiding higher-order computations. Furthermore, the estimation system 100 and the measurement module 130 can naturally filter wear interference and measurement noise (e.g., sensor interference) to a used battery by targeting certain frequency bands during measurements. Factoring the specific structure of the used battery can help targeting these frequency bands. For instance, impedance measurements by the estimation system 100 are impacted by the used battery having one of cylindrically rolled cells, stacked plates, etc., below a certain frequency. Thus, the estimation system 100 measuring above the certain frequency can remove the wear and aging interference through factoring battery structure.

In another example, the estimation system 100 relates battery chemistries with measurement frequencies. Certain battery chemistries have operating limits that impact interference sources. For instance, the operating limit is 100 kHz for lithium-ion batteries. As such, the contact and inductive interference from iron sources may be most prominent and magnified at or above 100 kHz. In this way, the estimation system 100 can filter irrelevant interference sources and target certain interference sources by impedance measurements above certain frequencies and compute the first derivative from the measurement curve over different frequency points.

FIG. 3B illustrates that changes between the real-parts from the first derivatives of the impedance values among multiple (e.g., two) frequency points can nullify, mitigate, eliminate, remove, etc., inductive interference (e.g., iron-based induction). Here, an external object 350 that is metallic, magnetic, etc., causes inductive interference with internal cells, modules, a cell array, etc., during impedance measurements. For instance, the internal cells may comprise aluminum, stainless steel, etc., material that inductively couples with the external object 350 near a used battery. This coupling may occur even with polymers, plastic, etc., as the housing and shielding for a battery module. As such, the estimation system 100 removing inductive interference can improve computations for a safety state and a residual value including wear-related defects.

As an additional feature, the estimation system 100 detects mechanical deformation and a shift by a module of the used battery from the inductive interference between the external object 350 and a contact tab. This can include detecting a cell shift within a module of the used battery. The mechanical deformation can be caused by a collision involving the vehicle, an accident, an external force, impact, modules shifting, geometric cell changes, etc. Similar to plating and other degradations, the estimation system 100 identifies and detects the mechanical deformation and the cell shift while avoiding invasive techniques that can damage battery hardware. In one example, the estimation system 100 detects mechanical deformation and the cell shift at a module level of the used battery from inductive interference between the external object 350 (e.g., a metallic object) and a contact tab within a module while avoiding dissembling the used battery to access battery cells.

Charts $340_1$ and $340_2$ illustrate relationships between real-parts of impedance measurements with deposition on a cell contact (e.g., metallic plating). Here, curves $320_1$ and $320_2$ represent the real impedance for the positive terminal 320. Curves $310_1$ and $310_2$ represent the real impedance for the negative terminal 310. As shown in charts $340_1$ and $340_2$, factors that may change impedance appear as interference against degradation (e.g., plating) and SOH estimation. As such, computing derivatives removes the impedance change caused by contact interference, inductive interference (e.g., iron-based induction), etc., to accurately estimate a safety state, SOS, etc. Furthermore, removing and mitigating certain interferences allows the estimation system 100 to estimate SOS since the impedance change caused by SOS may be comparatively less, smaller, etc., than certain interference sources.

In another example, deposition from contact interference has first derivative values that are noticeable in chart $340_1$ at a higher frequency than in chart $340_2$. Furthermore, inductive interference from an external object that has iron and exhibits magnetic properties has constant first derivatives. In either case, the estimation system 100 can reliably detect deposition, a safety state, and a residual value above with a frequency, above a certain frequency, etc., that magnifies and emphasizes degradation and plating for a used battery, thereby improving accuracy.

The estimation system 100 includes additional enhancements for predicting a residual value and a safety state from impedance measurement and a health state. For instance, the estimation system 100 measures the health state using acquired sensor data about the used battery with the testing equipment. Here, the sensor data can include an output voltage, an operating temperature, and the impedance at reduced temperatures. Furthermore, the safety state satisfying a parameter (e.g., ion deposition, contact thickness, etc.) can include labeling a characteristic of the safety state as one of material wear and an eddy current from inductive interference, and the material wear includes SEI growth on a battery cell associated with the used battery. Therefore, the estimation system 100 can accurately estimate the safety state and residual value of cells within the used battery from the real values of the first derivative non-invasively and identify reuse applications for the used battery.

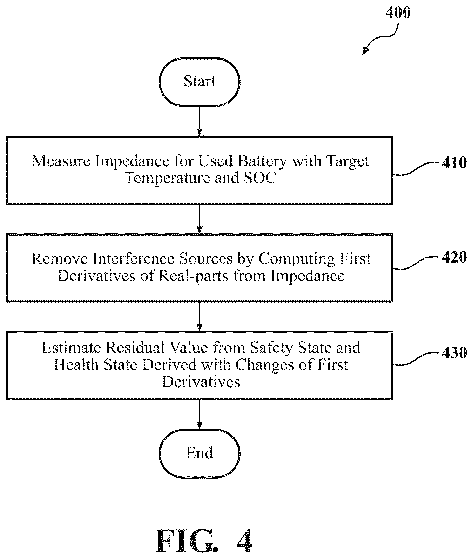

Turning to FIG. 4, a flowchart of a method 400 that is associated with estimating a residual value from a safety state and a health state derived with changes of first derivatives is illustrated. Method 400 will be discussed from the perspective of the estimation system 100 of FIG. 1. While the method 400 is discussed in combination with the estimation system 100, it should be appreciated that the method 400 is not limited to being implemented within the estimation system 100 but is instead one example of a system that may implement the method 400.

At 410, the measurement module 130 measures impedance for a used battery with a target temperature and SOC. As previously explained, in one embodiment, the estimation system 100 measures impedance at target temperature and SOC that improves the effectiveness of plating detection, computing a safety state, and deriving a residual value using first derivative computations. In one approach, these targets depend upon the internal architecture, cell layout (e.g., stacked layers, parallel, rolled cells, etc.), and chemistry profile of the used battery. In another example, the estimation system 100 adapts the targets with changes to impedance measurements involving the used battery that further improve computational accuracy.

Moreover, the targets can depend upon the internal architecture and chemistry of a used battery. The first derivative of the real-parts from impedance among the targets exhibit properties allowing the estimation system 100 to accurately detect metal deposition and degradation (e.g., a chemical degradation, a physical degradation, etc.) and mitigate interference sources. Correspondingly, the estimation system 100 can accurately compute a residual value for the used battery during testing from the interference sources associated with one of a cell, a module, a cell array, etc., within the used battery using the targets.

At 420, the estimation system 100 removes interference sources by computing first derivatives of real-parts from the impedance. The difference between the real-parts from the first derivatives of the impedance values among multiple frequency points can nullify, mitigate, eliminate, remove, etc., inductive interference (e.g., iron-based induction). Inductive interference from magnetic metals (e.g., iron) and a contact interference associated with one of a cell, a module, a cell array, etc., within the used battery can represent another interference source.

Moreover, the estimation system 100 converting real-parts of impedance to a percentage value can further minimize inductive interference such as an eddy current when detecting degradation and computing a residual value. This can also emphasize changes caused from metallic plating through observing linear relationships. In this way, the estimation system 100 reduces computations from monotonically increasing relationships rather than higher-order tasks.

As described above, in one embodiment, the estimation system 100 includes an analysis algorithm that retrieves context parameters about the used battery. For instance, the estimation system 100 factors the context parameters and the difference between real-parts from first derivatives of impedance values among the two frequency points when selecting a threshold for the safety state. The first derivatives of real-parts from impedance can be compared against the threshold. Here, a system analyzing the residual value can diagnose other defects besides internal degradation, plating, etc. In one approach, the threshold is associated with a plating level involving a particular battery chemistry (e.g., lithium-ion), usage profile (e.g., harsh weather, rough terrain, aggressive driving, etc.), etc. In this way, the estimation system 100 increases the reliability and accuracy of the safety state and residual value outputs through intelligently selecting the threshold.

As previously explained, the estimation system 100 estimates one of a safety state, a SOF, and the physical degradation for the used battery through computing eddy interference. Here, the estimation system 100 can utilize a linear relationship derived from first derivatives of real-parts associated with impedance measurements. This allows the estimation system 100 to diagnose the physical degradation as one of material wear, SEI growth, and an eddy current from inductive interference while avoiding complex testing tasks. This can include the estimation system 100 computing eddy interference for the interference sources using a linear relationship derived from the first derivatives of real-parts associated with measured interference. The estimation system 100 can identify plating of a terminal within the used battery by comparing a difference between two values of a first derivative within the frequency band with a threshold, and use regular testing equipment to identify the plating without dissembling cells associated with the used battery and calculate the safety state using a degree of the plating.

In various implementations, the estimation system 100 identifies plating of a terminal within the used battery from a difference between two or more values of a first derivative within the frequency band using the testing equipment without disassembling cells associated with the used battery. Furthermore, the estimation system 100 can compute a safety state for the used battery without impedance tracking from a timepoint that the used battery is manufactured.

At 430, the estimation system 100 estimates a residual value from a safety state and a health state derived with changes of the first derivatives. For instance, the residual state is a SOF that weights a SOS with a SOH. Here, the SOH can indicate one of a remaining capacity and a charging capacity of the used battery. In one approach, the estimation system 100 derives the SOH using output voltage, average operating temperature, and impedance from the average temperatures. As such, the estimation system 100 can reliably output one of a safety state that indicates degradation such as metallic plating and a residual value for the used battery. This allows related systems to identify that the used battery is viable for reuse and target particular applications. Otherwise, the systems generate a recycling plan from the output since the used battery is defective and worn beyond repair. Accordingly, the estimation system 100 can output a residual value about the used battery that indicates an available degree of the used battery being a power source in a reuse application.

Detailed embodiments are disclosed herein. However, it is to be understood that the disclosed embodiments are intended as examples. Therefore, specific structural and functional details disclosed herein are not to be interpreted as limiting, but merely as a basis for the claims and as a representative basis for teaching one skilled in the art to variously employ the aspects herein in virtually any appropriately detailed structure. Furthermore, the terms and phrases used herein are not intended to be limiting but rather to provide an understandable description of possible implementations. Various embodiments are shown in FIGS. 1-4, but the embodiments are not limited to the illustrated structure or application.

The flowcharts and block diagrams in the figures illustrate the architecture, functionality, and operation of possible implementations of systems, methods, and computer program products according to various embodiments. In this regard, a block in the flowcharts or block diagrams may represent a module, segment, or portion of code, which comprises one or more executable instructions for implementing the specified logical function(s). It should also be noted that, in some alternative implementations, the functions noted in the block may occur out of the order noted in the figures. For example, two blocks shown in succession may, in fact, be executed substantially concurrently, or the blocks may sometimes be executed in the reverse order, depending upon the functionality involved.

The systems, components, and/or processes described above can be realized in hardware or a combination of hardware and software and can be realized in a centralized fashion in one processing system or in a distributed fashion where different elements are spread across several interconnected processing systems. Any kind of processing system or another apparatus adapted for carrying out the methods described herein is suited. A typical combination of hardware and software can be a processing system with computer-usable program code that, when being loaded and executed, controls the processing system such that it carries out the methods described herein.

The systems, components, and/or processes also can be embedded in a computer-readable storage, such as a computer program product or other data programs storage device, readable by a machine, tangibly embodying a program of instructions executable by the machine to perform methods and processes described herein. These elements also can be embedded in an application product which comprises the features enabling the implementation of the methods described herein and, which when loaded in a processing system, is able to carry out these methods.

Furthermore, arrangements described herein may take the form of a computer program product embodied in one or more computer-readable media having computer-readable program code embodied, e.g., stored, thereon. Any combination of one or more computer-readable media may be utilized. The computer-readable medium may be a computer-readable signal medium or a computer-readable storage medium. The phrase "computer-readable storage medium" means a non-transitory storage medium. A computer-readable storage medium may be, for example, but not limited to, an electronic, magnetic, optical, electromagnetic, infrared, or semiconductor system, apparatus, or device, or any suitable combination of the foregoing. More specific examples (a non-exhaustive list) of the computer-readable storage medium would include the following: a portable computer diskette, a hard disk drive (HDD), a solid-state drive (SSD), a ROM, an EPROM or flash memory, a portable compact disc read-only memory (CD-ROM), a digital versatile disc (DVD), an optical storage device, a magnetic storage device, or any suitable combination of the foregoing. In the context of this document, a computer-readable storage medium may be any tangible medium that can contain, or store a program for use by or in connection with an instruction execution system, apparatus, or device.

Generally, modules as used herein include routines, programs, objects, components, data structures, and so on that perform particular tasks or implement particular data types. In further aspects, a memory generally stores the noted modules. The memory associated with a module may be a buffer or cache embedded within a processor, a RAM, a ROM, a flash memory, or another suitable electronic storage medium. In still further aspects, a module as envisioned by the present disclosure is implemented as an ASIC, a hardware component of a system on a chip (SoC), as a programmable logic array (PLA), or as another suitable hardware component that is embedded with a defined configuration set (e.g., instructions) for performing the disclosed functions.

Program code embodied on a computer-readable medium may be transmitted using any appropriate medium, including but not limited to wireless, wireline, optical fiber, cable, radio frequency (RF), etc., or any suitable combination of the foregoing. Computer program code for carrying out operations for aspects of the present arrangements may be written in any combination of one or more programming languages, including an object-oriented programming language such as Java™, Smalltalk™, C++, or the like and conventional procedural programming languages, such as the "C" programming language or similar programming languages. The program code may execute entirely on the user's computer, partly on the user's computer, as a stand-alone software package, partly on the user's computer and partly on a remote computer, or entirely on the remote computer or server. In the latter scenario, the remote computer may be connected to the user's computer through any type of network, including a local area network (LAN) or a wide area network (WAN), or the connection may be made to an external computer (for example, through the Internet using an Internet Service Provider).

The terms "a" and "an," as used herein, are defined as one or more than one. The term "plurality," as used herein, is defined as two or more than two. The term "another," as used herein, is defined as at least a second or more. The terms "including" and/or "having," as used herein, are defined as comprising (i.e., open language). The phrase "at least one of ... and ...." as used herein refers to and encompasses any and all combinations of one or more of the associated listed items. As an example, the phrase "at least one of A, B, and C" includes A, B, C, or any combination thereof (e.g., AB, AC, BC, or ABC).

Aspects herein can be embodied in other forms without departing from the spirit or essential attributes thereof. Accordingly, reference should be made to the following claims, rather than to the foregoing specification, as indicating the scope hereof.

**Claims**

1. An estimation system comprising:
a memory storing instructions that, when executed by a processor, cause the processor to:

measure impedance for a used battery by testing equipment with a target temperature and a target state of charge (SOC), and the target temperature and the target SOC associated with chemical activity of the used battery;
remove interference sources by computing first derivatives of real-parts from the impedance;
estimate a residual value from a safety state and a health state derived with changes of the first derivatives within a frequency band; and
upon the residual value satisfying a parameter, transmit the residual value to a device and the device draws power from the used battery during a reuse operation.

2. The estimation system of claim 1, wherein the instructions to estimate the residual value further include instructions to:

compute eddy interference for the interference sources using a linear relationship derived from the first derivatives;
identify plating of a terminal within the used battery by comparing a difference between two values of a first derivative within the frequency band with a threshold, and use the testing equipment to identify the plating without dissembling cells associated with the used battery; and
calculate the safety state using a degree of the plating.

3. The estimation system of claim 2, wherein the instructions to estimate the residual value further include instructions to:

measure the health state using acquired sensor data about the used battery with the testing equipment, the sensor data including an output voltage, an operating temperature, and the impedance at reduced temperatures; and output the residual value by multiplying values of the safety state, the health state, and a weighting factor associated with an internal structure of the used battery.

4. The estimation system of claim 1, wherein the instructions for the safety state to satisfy the parameter further include instructions to:
label a characteristic of the safety state as one of material wear and an eddy current from inductive interference, and the material wear includes solid electrolyte interphase (SEI) growth on a battery cell associated with the used battery.

5. The estimation system of claim 1 further including instructions to:

detect mechanical deformation and a cell shift at a module level of the used battery from inductive interference between an object that is metallic and a contact tab associated with a battery module, wherein the mechanical deformation is associated with a collision involving a vehicle and the module level excludes dissembling the used battery to access battery cells; and upon satisfying a cycling parameter, compute the safety state for the used battery without impedance tracking from a timepoint that the used battery is manufactured.

6. The estimation system of claim 1 further including instructions to:

identify a temperature and a SOC according to a cell layout of the used battery; and filter wear interference to the used battery using impedance values from the frequency band.

7. The estimation system of claim 1 wherein:

the interference sources are an inductive interference from iron and a contact interference associated with one of a cell and a module within the used battery; and the SOC is one of a charge level and a discharge level associated with chemical degradation.

8. The estimation system of claim 1 wherein:

the health state is a state of health (SOH) that indicates one of a remaining capacity and a charging capacity of the used battery; the residual value is one of a state of functionality and a state of function (SOF) associated with the used battery and the residual value indicates a degree of the used battery available as a power source in a reuse application; and the reuse application is one of an industrial reuse, a residential reuse, and a commercial reuse for the used battery.

9. The estimation system of claim 1 wherein:

the safety state indicates plating within a cell of a module internal to the used battery; the frequency band is above a frequency having increased chemical breakdown and an ion response that is elevated associated with the used battery; and the parameter indicates that one of a cell and the module internally within the used battery has undetected plating on a surface of an anode associated with a threshold.

10. A method comprising:

measuring impedance for a used battery by testing equipment with a target temperature and a target state of charge (SOC), and the target temperature and the target SOC associated with chemical activity of the used battery; removing interference sources by computing first derivatives of real-parts from the impedance; estimating a residual value from a safety state and a health state derived with changes of the first derivatives within a frequency band; and upon the residual value satisfying a parameter, transmitting the residual value to a device and drawing power from the used battery by the device during a reuse operation.

11. The method of claim 10, wherein estimating the residual value further includes:

computing eddy interference for the interference sources using a linear relationship derived from the first derivatives; identifying plating of a terminal within the used battery by comparing a difference between two values of a first derivative within the frequency band with a threshold, and using the testing equipment identifying the plating without dissembling cells associated with the used battery; and calculating the safety state using a degree of the plating.

12. The method of claim 11, wherein estimating the residual value further includes:

measuring the health state using acquired sensor data about the used battery with the testing equipment, the sensor data including an output voltage, an operating temperature, and the impedance at reduced temperatures; and
outputting the residual value by multiplying values of the safety state, the health state, and a weighting factor associated with an internal structure of the used battery.

13. The method of claim 10, wherein the safety state satisfying the parameter further includes:
labeling a characteristic of the safety state as one of material wear and an eddy current from inductive interference, and the material wear includes solid electrolyte interphase (SEI) growth on a battery cell associated with the used battery.

14. The method of claim 10 further comprising:

detecting mechanical deformation and a cell shift at a module level of the used battery from inductive interference between an object that is metallic and a contact tab associated with a battery module, wherein the mechanical deformation is associated with a collision involving a vehicle and the module level excludes disassembling the used battery to access battery cells; and
upon satisfying a cycling parameter, computing the safety state for the used battery without impedance tracking from a timepoint that the used battery is manufactured.

15. The method of claim 10 further comprising:

identifying a temperature and a SOC according to a cell layout of the used battery; and
filtering wear interference to the used battery using impedance values from the frequency band.

Estimation System **100**

Data Store **140**

| Battery Metrics **150** | Impedance **160** |

Processor(s) **110**

Memory **120**

Measurement Module **130**

# FIG. 1

FIG. 2A

FIG. 2B

FIG. 2C

**FIG. 3A**

**FIG. 3B**

**400**

```
        ┌─────────┐
        │  Start  │
        └─────────┘
             │
             ▼
┌──────────────────────────────────────────┐
│ Measure Impedance for Used Battery with Target │────── 410
│         Temperature and SOC                │
└──────────────────────────────────────────┘
             │
             ▼
┌──────────────────────────────────────────┐
│ Remove Interference Sources by Computing First │────── 420
│   Derivatives of Real-parts from Impedance │
└──────────────────────────────────────────┘
             │
             ▼
┌──────────────────────────────────────────┐
│ Estimate Residual Value from Safety State and │────── 430
│   Health State Derived with Changes of First │
│              Derivatives                   │
└──────────────────────────────────────────┘
             │
             ▼
        ┌─────────┐
        │   End   │
        └─────────┘
```

# FIG. 4

Europäisches
Patentamt

European
Patent Office

Office européen
des brevets

# EUROPEAN SEARCH REPORT

**Application Number**

EP 25 21 3856

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2024/044827 A1 (ISHIGAKI MASANORI [JP] ET AL) 8 February 2024 (2024-02-08) | 1,8,10 | INV.<br>G01R31/367 |
| A | * paragraphs [0033] - [0037], [0041] - [0043], [0057] - [0062]; figures 1, 5a-8, 11-14 * | 2-7,9, 11-15 | G01R31/382<br>G01R31/389<br>G01R31/392 |
| | ----- | | |
| A | US 2024/429476 A1 (AKUTSU NAOTO [JP] ET AL) 26 December 2024 (2024-12-26) * paragraphs [0074] - [0102]; figure 7 * | 1-15 | |
| | ----- | | |
| A | US 2023/366937 A1 (KATRASNIK TOMAZ [SI] ET AL) 16 November 2023 (2023-11-16) * paragraphs [0096] - [0107]; figures 1-2 * | 1-15 | |
| | ----- | | |
| A | US 2024/094301 A1 (LUHTALA RONI [FI] ET AL) 21 March 2024 (2024-03-21) * paragraphs [0032] - [0067]; figures 1-10 * | 1-15 | |
| | ----- | | |

**TECHNICAL FIELDS SEARCHED (IPC)**

G01R

The present search report has been drawn up for all claims

| Place of search | Date of completion of the search | Examiner |
|---|---|---|
| Munich | 17 April 2026 | Maric, Viktor |

EPO FORM 1503 03.82 (P04C01)

## ANNEX TO THE EUROPEAN SEARCH REPORT
## ON EUROPEAN PATENT APPLICATION NO.

EP 25 21 3856

This annex lists the patent family members relating to the patent documents cited in  the above-mentioned European search report.
The members are as contained in the European Patent Office EDP file on
The European Patent Office is in no way liable for these particulars which are merely given for the purpose of information.

17-04-2026

| Patent document cited in search report | | Publication date | Patent family member(s) | | Publication date |
|---|---|---|---|---|---|
| US 2024044827 | A1 | 08-02-2024 | CN | 114764122 A | 19-07-2022 |
| | | | EP | 4262044 A1 | 18-10-2023 |
| | | | JP | 7347451 B2 | 20-09-2023 |
| | | | JP | 7605257 B2 | 24-12-2024 |
| | | | JP | 2022108602 A | 26-07-2022 |
| | | | JP | 2023139149 A | 03-10-2023 |
| | | | US | 2024044827 A1 | 08-02-2024 |
| | | | WO | 2022153874 A1 | 21-07-2022 |
| US 2024429476 | A1 | 26-12-2024 | EP | 4492533 A1 | 15-01-2025 |
| | | | JP | WO2023171010 A1 | 14-09-2023 |
| | | | JP | WO2023171619 A1 | 14-09-2023 |
| | | | JP | WO2023171620 A1 | 14-09-2023 |
| | | | US | 2024418794 A1 | 19-12-2024 |
| | | | US | 2024426929 A1 | 26-12-2024 |
| | | | US | 2024429476 A1 | 26-12-2024 |
| | | | WO | 2023171010 A1 | 14-09-2023 |
| | | | WO | 2023171619 A1 | 14-09-2023 |
| | | | WO | 2023171620 A1 | 14-09-2023 |
| US 2023366937 | A1 | 16-11-2023 | NONE | | |
| US 2024094301 | A1 | 21-03-2024 | CN | 117157543 A | 01-12-2023 |
| | | | EP | 4278196 A1 | 22-11-2023 |
| | | | EP | 4455698 A2 | 30-10-2024 |
| | | | ES | 2989046 T3 | 25-11-2024 |
| | | | FI | 129670 B | 30-06-2022 |
| | | | US | 2024094301 A1 | 21-03-2024 |
| | | | US | 2024426932 A1 | 26-12-2024 |
| | | | WO | 2023031501 A1 | 09-03-2023 |

EPO FORM P0459

For more details about this annex : see Official Journal of the European Patent Office, No. 12/82